# EUROPÄISCHE PATENTSCHRIFT

(11) **EP 4 473 325 B1**
(45) Veröffentlichungstag und Bekanntmachung des Hinweises auf die Patenterteilung: **08.04.2026**
(21) Anmeldenummer: 23707252.5
(22) Anmeldetag: 01.02.2023
(51) Int. Cl.: G01R 31/385, G01R 31/40

(54) **BATTERIEPRÜFSYSTEM MIT BASIS-SPANNUNGSWANDLERN UND BOOSTER-SPANNUNGSWANDLER**
BATTERY TESTING SYSTEM WITH BASE VOLTAGE CONVERTERS AND BOOSTER VOLTAGE CONVERTER
SYSTÈME DE TEST DE BATTERIES COMPRENANT DES CONVERTISSEURS DE TENSION DE BASE ET UN CONVERTISSEUR SURVOLTEUR

(30) Priorität: 02.02.2022 AT 500542022
(43) Veröffentlichungstag der Anmeldung: 11.12.2024
(73) Patentinhaber: AVL List GmbH, 8020 Graz (AT); AVL SET GMBH, 88239 Wangen (DE)
(72) Erfinder: SCHMIDT, Martin, 63225 Langen (DE); SCHMITT, Alexander, 88287 Grünkraut (DE); SEIFERT, Sven, 83071 Stephanskirchen (DE)
(74) Vertreter: Mathys & Squire
(86) Internationale Anmeldenummer: PCT/AT2023/060024
(87) Internationale Veröffentlichungsnummer: WO 2023/147613

(56) Entgegenhaltungen:
- WO-A1-2021/174278
- CN-A- 110 850 294
- DE-A1- 102015 215 233

## Beschreibung

Die Erfindung betrifft ein Prüfsystem zur gleichzeitigen Prüfung mehrerer Batterien, insbesondere Hochvoltbatterien und ein Verfahren zur Prüfung von mehreren Prüflingen mit einem Prüfsystem.

Der Bedarf an elektrischen Prüfsystemen steigt derzeit aufgrund der Elektrifizierung von verschiedenen bisher nicht elektrifizierten Technologiefeldern stark an. Prüfsysteme können dazu eingerichtet sein, die Belastungen des Lebenszyklus eines Prüflings nachzustellen und sind in der Lage, einen an einen Testkanal angeschlossenen Prüfling mit einer Leistung zu laden und/oder zu entladen, wie es das jeweilige Prüfverfahren erfordert. Dies gilt für jeden einzelnen Testkanal und jeden einzelnen Prüfling. Von besonderem Interesse ist die Prüfung von Batterien. Batterieprüfverfahren weisen häufig große Unterschiede zwischen den zu unterschiedlichen Zeitpunkten erforderlichen Prüfleistungen auf. Hierbei wird häufig für längere Zeiträume eine nur geringe Lade- oder Entladeleistung benötigt, während für kurze Zeiträume eine besonders hohe Lade- oder Entladeleistung an einem einzelnen Prüfling angefordert wird.

Bei den bekannten Prüfsystemen werden elektrische Wandler verwendet, um die erforderlichen Transferleistungen bereitzustellen. Hierbei ist jeweils ein Wandler mit einem Testkanal gekoppelt. Um den Leistungsbedarf jedes Prüflings abzudecken, sind die Wandler auf die maximal am jeweiligen Testkanal bereitzustellende Leistung ausgelegt. Derartige Wandler müssen also einen großen Leistungsumfang abdecken und sind daher besonders teuer. Der maximale Leistungsumfang wird in vielen Anwendungsfällen jedoch nur für jeweils sehr kurze Zeiträume genutzt. Bei einer solchen eins-zu-eins-Kopplung zwischen Wandler und Testkanal ist eine ausschließliche Verwendung von günstigen Wandlern mit geringerem Leistungsumfang dennoch aufgrund des für die Prüfung erforderlichen Leistungsumfang nicht möglich.

Beispielsweise offenbart die Patentschrift WO2021/174278 A1 eine Wandleranordnung mit mindestens zwei Wandlern und einer mit den Wandlern verbundenen Steuereinheit. Die Steuereinheit ist dazu ausgebildet, kontinuierlich oder in diskreten Zeitintervallen den Wandlern ihren zulässigen elektrischen Leistungsbereich insbesondere ihren minimalen Leistungswert Pₘᵢₙ und/oder ihren maximalen Leistungswert Pₘₐₓ, und die aktuelle Leistungsbilanz der einzelnen Umrichter zu ermitteln oder von diesen zu erhalten. Ferner ist sie dazu eingerichtet, den zulässigen elektrischen Leistungsbereich der Wandler so zu verändern, dass die Leistungsbilanz der gesamten Wandlergruppe einen vorgegebenen Bereich nicht verlässt.

Ferner offenbart Dokument DE102015215233 A1 ein System für ein Batteriemanagementsystem in Fahrzeugen, das zur Diagnose von Lecks in elektronischen Teilen und zum Warten der Führung eines Antriebszustands dient. Das System überwacht den Isolationswiderstand elektronischer Komponenten während des Betriebs des Fahrzeugs, um Sicherheitsrisiken wie Stromschläge zu vermeiden. Das Batteriemanagementsystem ermittelt den Isolationswiderstands-Durchschlag und lokalisiert defekte Teile. Es kann das Batterierelais abschalten, um das Fahrzeug bei Bedarf anzuhalten. Das System ist dazu eingerichtet, schrittweise Messungen des Isolationswiderstands in verschiedenen Fahrzeugzuständen durchzuführen, von der Einschaltung über den Start des Motors bis hin zum Betrieb verschiedener Lastteile wie Antriebsmotor und Klimaanlage.

Ferner offenbart Dokument CN 110850294 A ein Prüfsystem für Batteriepacks. Das Prüfsystem umfasst einen bidirektionalen DC/DC-Wandler, ein AC/DC-Stromversorgungsmodul, einen Controller, einen oberen Computer, einen ersten zu prüfenden Batteriesatz und einen zweiten zu prüfenden Batteriesatz. Ein Ende des bidirektionalen DC/DC-Wandlers ist mit einem Ende des Controllers verbunden, das andere Ende des bidirektionalen DC/DC-Wandlers ist mit dem ersten zu prüfenden Batteriesatz verbunden und das andere Ende des Controllers ist mit dem zweiten zu prüfenden Batteriesatz und dem AC/DC-Stromversorgungsmodul verbunden.

Grundsätzlich ist nicht ausgeschlossen, dass eine Bedarfsleistung von mehr als einem Wandler zur Verfügung gestellt wird. Hierdurch könnte eine hohe Leistung innerhalb eines kurzen Zeitraums transferiert werden. Besteht bei Prüfsystemen jedoch die Möglichkeit, dass innerhalb eines kurzen Zeitraums eine hohe Leistung im Bereich von kW oder MW transferiert wird, sind hohe Sicherheitsanforderungen zu erfüllen, die das Risiko einer fehlerhaften Schaltung und einem daraus entstehenden Kurzschluss verhindern. Eine einfache Kopplung von mehreren Wandlern, um bei Bedarf zusätzliche Leistung zu transferieren, führt schon bei wenigen Wandlern zu sehr komplexen Sicherheitssysteme, wobei eine hohe Komplexität aufgrund des damit einhergehenden Ausfallrisikos einzelner Teile nachteilig für die Sicherheit des Prüfsystems ist.

Es ist daher die Aufgabe der Erfindung, in kostengünstiger und einfacher Weise die voranstehend beschriebenen Nachteile zumindest teilweise zu beheben. Insbesondere ist es Aufgabe der vorliegenden Erfindung, ein Prüfsystem zur gleichzeitigen Prüfung mehrerer Prüflinge bereitzustellen, dass gegenüber bestehenden Prüfsystemen ohne Einschränkungen der Sicherheit kostengünstiger herzustellen ist.

Die Aufgabe wird durch ein Prüfsystem mit den Merkmalen des Anspruchs 1 sowie einem Verfahren zur Prüfung von einem oder mehreren Prüflingen nach Anspruch 17 gelöst. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Prüfsystem und jeweils umgekehrt, so dass bezüglich der Offenbarung zu den einzelnen Erfindungsaspekten stets wechselseitig Bezug genommen wird bzw. werden kann.

Gemäß einem ersten Aspekt liefert die Erfindung ein Prüfsystem zur gleichzeitigen Prüfung mehrerer Batterien, insbesondere Hochvoltbatterien, umfassend: einen Gleichspannungszwischenkreis, mehrere an den Gleichspannungszwischenkreis angeschlossene Basis-Wandler, die jeweils über eine Anschlussleitung mit einem Testkanal schaltbar verbunden sind, einen an den Gleichspannungszwischenkreis angeschlossenen Booster-Wandler, der während eines Betriebs des Prüfsystems über eine Boosterleitung und jeweils einen Zuschaltknoten an verschiedene der Anschlussleitungen zu wenigstens einem der Testkanäle zuschaltbar ist, eine Steuereinheit zur Steuerung der Basis-Wandler und des Booster-Wandler entsprechend einem gewünschten Leistungstransfer; wobei jede Anschlussleitung einen sicherheitsgerichteten Schalter zwischen Testkanal und Zuschaltknoten aufweist.

Als Prüfsystem wird eine Vorrichtung zur gleichzeitigen Prüfung von physikalischen Eigenschaften mehrerer Prüflinge verstanden. Insbesondere ist das Prüfsystem dazu geeignet elektrische Eigenschaften von Prüflingen bei unterschiedlichen Temperaturen zu prüfen. Als Prüflinge kommen beispielsweise Batterien, insbesondere Hochvoltbatterien infrage, wie sie beispielsweise in elektrisch angetriebenen Fahrzeugen eingesetzt werden. Als Batterien werden sowohl einzelne Zellen, zu Modulen zusammengeschaltete Zellen und zu Packs zusammengeschaltete Module verstanden. Weiterhin ist es grundsätzlich möglich, mit dem Prüfsystem Wechselrichter, Brennstoffzellen, Antriebsstränge, DC/DC-Wandler, Ladegeräte oder andere elektrische Leistung transferierende Vorrichtungen zu prüfen. Vorzugsweise ist das Prüfsystem ein leistungselektronisches Prüfsystem.

Eine Hochvoltbatterie ist ein Speicher für elektrische Energie. Sie besteht aus mehreren zusammengeschalteten Elementen und aus wenigen bis Tausenden parallel und seriell zusammengeschalteten Batteriezellen oder Zellenblöcken.

Ein Gleichspannungszwischenkreis ist ein Gleichspannungs-Schaltkreis, der dazu eingerichtet ist, elektrische Leistung zwischen unterschiedlichen Einheiten des Prüfsystems zu übertragen. Die vom Gleichspannungszwischenkreis bereitgestellte Spannung sollte auch unter Last möglichst konstant sein und kann beispielsweise bei 750V liegen. Der Gleichspannungszwischenkreis kann auch mehr als zwei Spannungsniveaus und damit eine Multi-Level-Topologie aufweisen. Anstelle von einem Gleichspannungszwischenkreis kann alternativ oder zusätzlich auch ein Gleichstromzwischenkreis genutzt werden.

Ein Basis-Wandler bezeichnet eine elektrische Schaltung, die eine am Eingang zugeführte Gleichspannung in eine Gleichspannung mit höherem, niedrigerem oder invertiertem Spannungsniveau umwandelt und dazu ausgelegt ist, über seinen Ausgang ein Basis-Spannungsniveau und/oder ein Basis-Leistungsniveau zu transferieren. Neben dem Anwendungsfall der Umwandlung einer Gleichspannung in einer Gleichspannung in eine andere Gleichspannung kann der Basis-Wandler grundsätzlich auch zur Umwandlung einer Wechselspannung in eine Gleichspannung, einer Wechselspannung in eine andere Wechselspannung oder einer Gleichspannung in eine Wechselspannung ausgelegt sein. Die Umwandlung erfolgt mithilfe einer leistungselektronischen Schaltung und eines oder mehrerer Energiespeicher. Eine Basis-Versorgungsleistung kann beispielsweise zwischen 20kW und 300kW liegen. Basis-Wandler sind grundsätzlich dazu eingerichtet, elektrische Leistung bidirektional zu wandeln.

Eine Anschlussleitung ist eine elektrische Leitung, die dazu eingerichtet ist, einen Basis-Wandler mit einem Testkanal zu verbinden. Die Anschlussleitung ist vorzugsweise mehrpolig ausgestaltet.

Ein Testkanal ist eine Einrichtung, die dazu dient, einen Prüfling (unit under test, UUT) zur Testung anzuschließen. Ein Prüfling kann über mehrere Testkanäle angeschlossen sein. Der Testkanal kann Teil einer Prüfeinrichtung sein. Die Prüfeinrichtung kann beispielsweise ein Batterieprüfstand, ein Brennstoffzellenprüfstand, ein Ladegerätprüfstand, ein Antriebsstrangprüfstand oder ein Prüfstand zur Prüfung von Gleichspannungswandler sein. Ein Testkanal kann mehrpolig ausgestaltet sein.

Ein Booster-Wandler bezeichnet ebenso wie der Basis-Wandler eine elektrische Schaltung, die eine am Eingang zugeführte Gleichspannung in eine Gleichspannung mit höherem, niedrigerem oder invertiertem Spannungsniveau umwandelt. Booster-Wandler sind grundsätzlich ebenfalls dazu eingerichtet, elektrische Leistung bidirektional zu wandeln und können identisch zu den Basis-Wandlern ausgestaltet sein. Vorzugsweise sind Booster-Wandler jedoch so ausgestaltet, dass sie an dessen Ausgang ein Leistungsniveau transferieren, das bei einem zum Basis-Wandler passenden Spannungsniveau über dem Basis-Leistungsniveau liegt.

Unter einem Betrieb des Prüfsystems ist zu verstehen, dass einen Prüfling am Prüfsystem angeschlossen ist und ein Prüflauf am Prüfsystem durchgeführt wird. Hierbei kann ein Leistungstransfer zum Prüfling oder von dem Prüfling weg stattfinden oder das Prüfsystem befindet sich in einem Zustand, in dem kein Leistungstransfer von oder zum Prüfling stattfindet. Der Leistungstransfer ist grundsätzlich nicht konstant. Die Eigenschaft, dass ein Booster-Wandler während des Betriebs des Prüfsystems zuschaltbar ist, umfasst somit auch notwendige Sicherheitseinrichtungen, die eine Zuschaltung und Abschaltung ermöglichen, ohne, dass das Prüfsystem oder ein Operator des Prüfsystems Schaden nimmt.

Eine Boosterleitung ist eine von einem Booster-Wandler ausgehende elektrische Leitung. Mit der Boosterleitung sind mehrere Anschlussleitungen schaltbar verbunden. Die Boosterleitung kann aus mehreren, beispielsweise durch Knoten verbundenen, Teilstücken bestehen. Insbesondere kann vorgesehen sein, dass lediglich Teilstücke der Boosterleitung mit den mehreren Anschlussleitungen schaltbar verbunden sind. Es ist darauf zu achten, dass im Betrieb des Prüfsystems jeweils nur eine oder keine Anschlussleitung an die Boosterleitung angeschlossen ist. Bei mehreren gleichzeitig im Betrieb des Prüfsystems an die Boosterleitung angeschlossenen Anschlussleitungen besteht die Gefahr eines ungewollten Spannungsübertrags, sofern unterschiedliche Spannungen an den jeweils angeschlossenen Anschlussleitungen anliegen.

Ein Zuschaltknoten ist ein Punkt im elektrischen Netzwerk des Prüfsystems an dem zwei Anschlüsse der Anschlussleitung und ein Anschluss der Boosterleitung zusammentreffen, wobei sich der Strom in diesem Punkt verzweigen kann. An dem Zuschaltknoten kann somit ein in der Anschlussleitung fließenden Strom mit einem in der Boosterleitung fließenden Strom überlagert werden.

Die Steuereinheit ist dazu eingerichtet, die Basis-Wandler und den oder die Booster-Wandler zu steuern, also die von den Wandlern zu transferierende Leistung einzustellen. Hierzu ist die Steuereinheit mit den Wandlern signaltechnisch gekoppelt. Die Steuereinheit kennt den Inhalt der Speichereinheit und die Sollwerte für Strom und/oder Spannung und/oder Leistung und misst die dazugehörigen Ist-Werte oder sammelt diese ein. Ferner kann die Steuereinrichtung dazu eingerichtet sein, die aktuellen oder zukünftigen Sollwerte zur Vorsteuerung einer Einspeisung in den DC Zwischenkreis (z.B. Active-Front-End-Wandler) und/oder der Speichereinrichtung zu berechnen.

Ein Leistungstransfer kann positiv, negativ oder Null sein, umfasst also sowohl eine Leistungsabgabe wie auch eine Leistungsaufnahme.

Ein sicherheitsgerichteter Schalter ist nach sicherheitsgerichteten Konstruktionsprinzipien konstruiert, die eingehalten werden müssen, damit das Risiko einer Fehlfunktion minimiert werden kann. Sicherheitsgerichtete Schalter sind insbesondere dazu eingerichtet, den eigenen Schaltzustand und/oder ein eigene Fehlfunktion zu detektieren oder detektierbar zu machen.

Vorzugsweise ist bei dem erfindungsgemäßen Prüfsystem der Gleichspannungszwischenkreis über einen Netzumrichter an ein Stromnetz angeschlossen.

Der Netzumrichter wandelt eine am Prüfstand verfügbare Spannung, beispielsweise eine mehrphasige Netzspannung in eine Gleichspannung um, die als Zwischenkreisspannung bezeichnet wird. Der Netzumrichter kann ein Gleichrichter (AC-DC-Konverter, Active-Front-End-Konverter) sein, beispielsweise ein geschalteter Brückengleichrichter. Die Spannungsumwandlung erfolgt insbesondere bidirektional. Eine Umwandlung der AC-Spannung in eine DC-Spannung führt zu genaueren Ansteuerungen durch die einer glattere Eingangsspannung,

Ein Stromnetz ist ein Netzwerk zur Übertragung und Verteilung elektrischer Energie. Das Stromnetz ist vorzugsweise ein Wechselspannungsnetz, kann aber auch ein Gleichspannungsnetz sein. Sofern das Netz ein Gleichspannungsnetz ist, ist als Netzumrichter ein DC/DC-Konverter vorgesehen, der die Netzspannung in eine zweckmäßige Zwischenkreisspannung umwandelt.

Ein weiterer Vorteil ist erzielbar, wenn das Prüfsystem ferner eine Speichereinrichtung umfasst, die dazu eingerichtet ist, Leistung zu wenigstens einem der Testkanäle oder von wenigstens einem der Testkanäle zu transferieren, wobei die Speichereinrichtung direkt oder über eine zusätzliche Leistungselektronik an den Gleichspannungszwischenkreis angeschlossen ist.

Die Speichereinrichtung ist eine Einrichtung zur Speicherung elektrischer Energie und kann Akkumulatoren, Superkondensatoren oder auch andere physikalische oder chemische Energiespeichereinrichtungen umfassen. Die Speichereinrichtung dient der Stabilisierung des Gleichspannungszwischenkreises für Situationen, in denen das Prüfsystem dem Gleichspannungszwischenkreis viel Leistung entnimmt oder viel Leistung in den Gleichspannungszwischenkreis abgibt.

Weiter von Vorteil ist es, wenn die Speichereinrichtung einen Chopper umfasst.

Ein Chopper ist ein schalterbarer Widerstand, der bei Bedarf Leistung in Wärme umwandelt und so elektrische Leistung dem Prüfsystem entnimmt. Der Chopper kann aktiv oder passiv gesteuert sein.

Vorteilhaft ist es weiter, wenn das Prüfsystem, ferner einen Active-Front-End-Wandler umfasst, der dazu eingerichtet ist, Leistung in das Stromnetz oder aus dem Stromnetz zu transferieren.

Der Active-Front-End-Wandler ist ein steuerbarer Gleichrichter mit bidirektionalen Leistungstransfer zwischen Wechsel- und Gleichstrom und der Möglichkeit zur Rückspeisung von Leistung in das Stromnetz. Sofern das Prüfsystem derart mit einem Stromnetz verbunden ist, dass Strom vom Prüfsystem in das Stromnetz rückführbar ist, ist notwendig, dass das Prüfsystem einen aktiven Netzstromrichter (Active-Front-End-Wandler) umfasst.

Insbesondere kann vorgesehen sein, dass der Basis-Wandler in einem ersten Leistungsbereich betreibbar ist und der Booster-Wandler in einem zweiten Leistungsbereich betreibbar ist und der erste Leistungsbereich kleiner ist als der zweite Leistungsbereich.

In Prüfsystemen zur Prüfung von Hochvoltbatterien kann der erste Leistungsbereich beispielsweise Leistungen bis 300kW abdecken und der zweite Leistungsbereich Leistungen bis 750kW abdecken. Wandler mit besonders großen Leistungsbereichen sind in ihrer Anschaffung teurer als solche mit geringeren Leistungsbereichen. Ein Kostenvorteil in der Herstellung des Prüfsystems kann durch die unterschiedlich hohen Leistungsbereiche noch weiter verstärkt werden.

Weiter von Vorteil ist es, wenn das Verhältnis der Anzahl von Booster-Wandlern zur Anzahl von Basis-Wandlern im Prüfsystem zwischen 1/2 und 1/6, insbesondere zwischen 1/3 und 1/5 beträgt.

Das Verhältnis der Anzahl von Booster-Wandlern zur Anzahl von Basis-Wandlern ist entsprechend der Auslastung der Booster-Wandler optimierbar. Hierzu sollte ein Booster-Wandler zur Verfügung stehen, wenn er zur Bereitstellung höherer Transferleistungen benötigt wird, aber geringe Standzeiten aufweisen, in denen nicht auf dessen Leistung zurückgegriffen werden muss. Das Verhältnis ist vom jeweiligen Einsatzzweck und den Leistungsbereichen der Basis-Wandler und der Booster-Wandler abhängig. Bei Prüfsystemen für Hochvoltbatterien und den damit verbundenen Prüfläufen kann ein Verhältnis von 4 Basis-Wandlern pro Booster-Wandler einen kostenoptimierten Kompromiss darstellen.

Vorteilhaft ist es weiter, wenn über jedem der sicherheitsgerichteten Schalter eine Spanungsmesseinrichtung angeordnet ist.

Die Spannungsmesseinrichtung ist dazu eingerichtet, die Spannung auf beiden Seiten eines Schalters zu messen, so dass ein Schließen des Schalters bei unerwünschten Spannungsdifferenzen auf beiden Seiten des Schalters verhindert werden kann. Diese Messung wird vorzugsweise bei allen Schaltern des Prüfsystems durchgeführt. Die von der Spannungsmessung aufgenommenen Daten werden an die Steuereinheit übertragen.

Ein weiterer Vorteil ist erzielbar, wenn wenigstens einer der sicherheitsgerichteten Schalter eine Parallelschaltung von mehreren Schaltern aufweist.

Die Parallelschaltung kann insbesondere aus einem widerstandsgekoppelten Schalter und einem widerstandsfreien Schalter aufweisen. Wird der widerstandsgekoppelte Schalter zuerst geschlossen, werden Spannungsdifferenzen auf beiden Seiten des sicherheitsgerichteten Schalters derart ausgeglichen, dass keine zu hohen Ströme fließen, die Schäden verursachen können oder das Prüfergebnis verfälschen können. Über den anschließend zu schließenden widerstandsfreien Schalter wird in geschlossener Position der gesamten Strom praktisch verlustfrei geleitet.

Ferner ist von Vorteil, wenn zumindest einer der sicherheitsgerichteten Schalter zur Schaltung von einem mit Rippelstrom überlagertem Gleichstrom eingerichtet ist.

In dieser besonderen Ausführungsform der Erfindung weist der entsprechende sicherheitsgerichtete Schalter eine Parallelschaltung von mehreren Schaltern auf, wobei einer der Schalter der Parallelschaltung zur Leitung von Gleichstrom und ein anderer Schalter der Parallelschaltung zur Leitung von Wechselstrom ausgestaltet ist. In Prüfsystemen für Hochvoltbatterien sind die zu transferierenden Ströme häufig von einem Wechselstrom oder Rippelstrom (AC-Anteil) überlagerte Gleichströme (DC-Anteil). Die Rippelströme können durch eine Modulation des Sollwerts des Booster-Wandlers erzeugt werden. Üblicherweise wird der Großteil der Leistung über den Gleichstrom übertragen, während ein betragsmäßig kleinerer Teil über den Wechselstrom bzw. Rippelstrom übertragen wird. Um eine realistische Prüfsituation zu gewährleisten, ist eine Übertragung beider Anteile notwendig. Ein einfacher Schalter für hohe Leistungen ist grundsätzlich nicht dafür geeignet, derartige Überlagerungen von DC- und AC-Anteilen zu übertragen, da für die hohen Ströme des DC-Anteils Leitungen mit großem Leitungsdurchmesser benötigt werden und AC-Anteile des Stroms nur auf der Oberfläche solcher Leitungen fließen können. Durch eine Parallelschaltung eines AC-Schalters und eines DC-Schalters ist eine bessere Übertragung beider Anteile möglich. Wegen der unterschiedlichen Stromstärken der AC-Anteile und der DC-Anteile kann der AC-Schalter zur Durchleitung kleinerer Ströme als der DC-Schalter ausgestaltet sein. Insbesondere kann eine solche Parallelschaltung dazu eingerichtet sein, in einem Schaltprozess den AC-Schalter zuerst und anschließend den DC-Schalter zu schließen.

Weiter vorzugsweise kann vorgesehen sein, dass die Speichereinrichtung einen schnellen Speicher mit schneller Zugriffszeit und einen langsamen Speicher mit langsamer Zugriffszeit umfasst, und der schnelle Speicher eine geringere Kapazität als der langsame Speicher aufweist.

Die Kombination aus schnellem Speicher und langsamem Speicher ermöglicht eine kostenoptimierte Nutzung beider Systeme. Während schnelle Speicher kurzfristige Laständerungen aufnehmen und abgeben können, ermöglichen langsame Speicher grundsätzlich eine verlustärmere Speicherung elektrischer Energie bei geringeren Kosten. Als schnelle Speicher kommen beispielsweise Superkondensatoren, als langsame Speicher Akkumulatoren infrage.

Besonders bevorzugt umfasst die Boosterleitung einen Boosterschalter zum Zuschalten einer Boosterleistung zu wenigstens einem der Testkanäle.

Der Boosterschalter kann als ein Schütz-Schalter ausgestaltet sein, ist aber vorzugsweise ein Leistungselektronik-Halbleiterschalter wie etwa ein IGBT oder MOSFET. Der Leistungselektronik-Halbleiterschalter kann als Halbleitermaterial Si, GaN,SiC oder auch andere Halbleitermaterialien umfassen. Beim Zuschalten der Boosterleistung zur Basisleistung ist eine geringe Schaltzeit hilfreich, um dem in einem Prüflauf vorgegebenen Spannungsverlauf möglichst genau zu folgen und auch bei schnellen Änderungen einer zu transferierenden Leistung spannungsfrei schalten zu können. Aufgrund der schnellen Schaltzeiten eines Leistungselektronik-Halbleiterschalters wird ermöglicht, die Boosterleitung im Betrieb zu einem beliebigen Zeitpunkt, auch während Laständerungen, zu jeweils einer der mehreren Anschlussleitungen spannungsfrei zuzuschalten. Leistungselektronik-Halbleiterschalter erreichen eine Schaltzeit im Bereich von Nanosekunden, wobei die Schaltzeiten von Schütz-Schaltern etwa im Bereich von 10 Millisekunden liegen und damit deutlich langsamer sind. Um zu verhindern, dass mehrere Testkanäle über die Boosterleitung miteinander kurzgeschlossen werden, weisen die Boosterschalter vorzugsweise einen sicherheitsgerichteten Eingang auf. Der sicherheitsgerichtete Eingang kann verhindern oder erlauben, dass der Schaltzustand des Boosterschalters geändert wird. Ein solcher sicherheitsgerichteter Eingang kann auf einfache Weise analog zu einem Safe-Torque-Off-Schalters eines Antriebsstromrichters realisiert werden. Nur wenn der sicherheitsgerichtete Eingang eine Änderung des Schaltzustands erlaubt, kann der Schalter geschlossen oder geöffnet werden. Die Steuereinheit kann ferner so eingerichtet sein, dass lediglich ein Boosterschalter zu einem Zeitpunkt geschlossen werden darf. Ein Kanal würde somit erst zur Zuschaltung über den Boosterschalter freigegeben werden, wenn sichergestellt ist, dass kein weiterer Kanal zugeschaltet werden kann. Ein sicherheitsgerichteter Eingang verzögert grundsätzlich nicht die Schaltzeit des Boosterschalters.

Weiter vorzugsweise weisen die Basis-Wandler und/oder der oder die Booster-Wandler jeweils Stützkondensatoren auf und eine Ausgangskapazität der Stützkondensatoren des Booster-Wandlers oder der Booster-Wandler kleiner ist als eine Ausgangskapazität von Stützkondensatoren der Basis-Wandler.

Die Ausgangskapazitäten der Wandler stützen die Ausgangsspannung und halten sie stabil. Sollte jedoch einer der Basis-Wandler oder einer der Booster-Wandler zu einem Testkanal nicht spannungsfrei zugeschaltet werden, fließt ein Strom zwischen Testkanal und Stützkondensator. Die Stromstärke hängt von der Größe der zugeschalteten Ausgangskapazität ab und kann auch den Prüflauf beeinflussen. Solche Fehlschaltungen können insbesondere bei fehlerhaften Spannungsmessungen auftreten. Es ist daher vorteilhaft, die nicht direkt beim Testkanal angeordneten Kapazitäten möglichst klein zu halten. Hierzu gehören insbesondere die Ausgangskapazitäten der regelmäßig zugeschalteten Booster-Wandler. Der Booster-Wandler kann auch einen Multi-Level-Konverter umfassen. In diesem Fall kann auf eine Ausgangskapazität verzichtet werden.

Vorteilhaft ist es weiter, wenn wenigstens einer der Basis-Wandler gegenüber dem Gleichspannungszwischenkreis galvanisch getrennt ist.

Unter galvanischer Trennung wird das Vermeiden der elektrischen Leitung zwischen zwei Stromkreisen, zwischen denen Leistung oder Signale ausgetauscht werden sollen verstanden. Bei galvanischer Trennung sind die elektrischen Potentiale voneinander getrennt und die Stromkreise sind dann untereinander potentialfrei. Vorzugsweise ist auch der Booster-Wandler gegenüber dem Gleichspannungszwischenkreis galvanisch getrennt. Besonders bevorzugt sind alle Basis-Wandler und/oder alle Booster-Wandler gegenüber dem Gleichspannungszwischenkreis galvanisch getrennt. Die galvanische Trennung bietet höhere Sicherheit, ermöglicht genauere Messungen der Spannung, unabhängig vom Gleichspannungszwischenkreis und verhindert elektromagnetische Störungen sowie ungewollte Wechselwirkungen zwischen den Testkanälen.

Ein weiterer Vorteil ist erzielbar, wenn die sicherheitsgerichteten Schalter signaltechnisch mit einem Safety-System verbunden sind.

Das Safety-System steuert insbesondere die sicherheitsgerichteten Schalter. Über einen Isolationsmonitor wird jeweils gemessen, ob eine vorgesehene galvanische Trennung von Basis-Wandlern und/oder Booster-Wandlern intakt ist. Wird eine Störung in Zusammenhang mit einer oder mehreren galvanischen Trennungen gemessen, öffnet das Safety-System in Zusammenhang mit der Störung stehende sicherheitsgerichtete Schalter und/oder verhindert, dass diese geschlossen werden. Ferner ist die Steuereinrichtung zur Steuerung der sicherheitsgerichteten Schalter eingerichtet.

Auch ist es denkbar, dass das Prüfsystem einen zweiten an den Gleichspannungszwischenkreis angeschlossenen Booster-Wandler, der während eines Betriebs des Prüfsystems zu der Boosterleitung zuschaltbar ist, umfasst.

Ein zweiter Booster-Wandler kann in gleicher oder unterschiedlicher Weise wie der erste Booster-Wandler ausgestaltet sein. Der zweite Booster-Wandler kann mit einer zweiten Boosterleitung verbunden sein, die wiederum über jeweils einen Zuschaltknoten an verschiedene der Anschlussleitungen zu wenigstens einem der Testkanäle zuschaltbar ist. Die Zuschaltung des zweiten Booster-Wandlers zu der Boosterleitung des ersten Booster-Wandlers kann über einen mit beiden Boosterleitungen in Verbindung stehenden Verbinderschalter erfolgen. Vor dem Zuschalten wird über dem Verbinderschalter die Spannung gemessen und sofern notwendig, derart geregelt, dass die Zuschaltung spannungsfrei erfolgt. Neben einem zweiten Booster-Wandler kann das Prüfsystem je nach Bedarf noch weitere Booster-Wandler umfassen, die in gleicher Weise wie die ersten beiden Booster-Wandler verbunden und zuschaltbar sein können.

Gemäß einem zweiten Aspekt liefert die Erfindung ein Verfahren zur Prüfung von einem oder mehreren Prüflingen mit einem Prüfsystem insbesondere nach einem der vorhergehenden Ansprüche, umfassend die Schritte:
a) Anschließen eines Prüflings an einem der Testkanäle;
b) Starten eines Prüflaufs an dem Prüfling;
c) Senden einer Leistungsanforderung für einen Testkanal an die Steuereinheit;
d) Überprüfen, ob die angeforderte Leistung betragsmäßig größer ist als die vom Basis-Wandler transferierbare Leistung
e) Verbinden des Booster-Wandlers mit einem der Testkanäle, wenn die angeforderte Leistung betragsmäßig größer ist als die vom Basis-Wandler transferierbare Leistung;
f) Transferieren der angeforderten Leistung über den Basis-Wandler und den Booster-Wandler.

Als Prüfling kommt jede elektrische Energie abgebende oder aufnehmende Einheit infrage. Insbesondere kommen als Prüflinge infrage: Batterien, vorzugsweise wiederaufladbare Batterien, besonders bevorzugt Hochvoltbatterien, Inverter, Brennstoffzellen, elektrische Antriebsstränge, DC/DC-Wandler und elektrische Ladevorrichtungen.

In einem Prüflauf wird der Prüfling unter verschiedenen Bedingungen betrieben zur Erprobung seiner Funktion und Leistungsfähigkeit. Die Abfolge der verschiedenen Bedingungen ist im Prüflauf vor Beginn des Prüflaufs festgelegt. Bei Hochvoltbatterien können in dem Prüflauf beispielsweise Ladezyklen und Entladezyklen derart aufeinander folgen, wie sie während der Lebensdauer der Hochvoltbatterie erwartet werden. Üblicherweise werden an einer Prüfeinrichtung mit mehreren Testkanälen mehrere Prüfläufe gleichzeitig oder in kurzen Abständen nacheinander gestartet. Hierbei ist es vorteilhaft, wenn die Prüfläufe derart gestartet werden, dass während der gesamten Prüfdauer aller Prüfläufe jeweils nur einer der Testkanäle eine Leistungsanforderung sendet, die die Leistung des mit dem jeweiligen Testkanal verbundenen Basis-Wandlers übersteigt und somit auch nur einer der Testkanäle das Verbinden des und/oder der Booster-Wandler zum Transferieren der angeforderten Leistung erfordert.

Besonders bevorzugt werden an unterschiedlichen Testkanälen durchzuführende Prüfläufe derart aufeinander abgestimmt, dass Leistungsaufnahmen eines Testkanals mit Leistungsabgaben eines anderen Testkanals übereinstimmen. Auf diese Weise wird der Gleichspannungszwischenkreis weniger belastet und ein Leistungstransfer insgesamt reduziert. So können die Kosten zum Betrieb der Prüfeinrichtung gesenkt werden. Selbstverständlich ist eine solche Optimierung ausschließlich bei Prüflingen möglich, bei denen ein Leistungstransfer in beide Richtungen möglich ist, wie beispielsweise Hochvoltbatterien.

Bei dem Verfahren gemäß dem zweiten Aspekt der Erfindung ist vorzugsweise vorgesehen, dass die Leistungsanforderung wenigstens 1µs, vorzugsweise wenigstens 100µs vor Bereitstellung der Leistung an die Steuereinheit gesendet wird.

Die Steuereinheit kann durch Senden der Leistungsanforderung vor Bereitstellung der Leistung Spannungen zwischen zu schaltenden Teilen des Prüfsystems einander angleichen und dadurch die Schaltvorgänge verbessern.

Ferner liefert die Erfindung ein Computerprogrammprodukt, umfassend Befehle, die bei der Ausführung des Programms durch einen Computer diesen veranlassen, das Verfahren nach einem der Ansprüche 17 oder 18 auszuführen.

Schließlich liefert die Erfindung einen computerlesbaren Datenträger, auf dem das Computerprogrammprodukt nach Anspruch 19 gespeichert ist.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Figur 1: eine Schaltskizze eines erfindungsgemäßen Prüfsystems gemäß einer besonderen Ausführungsform der Erfindung; und
- Figur 2: einen vergrößerten Ausschnitt der Schaltskizze von Figur 1, auf dem zusätzliche Details dargestellt sind.

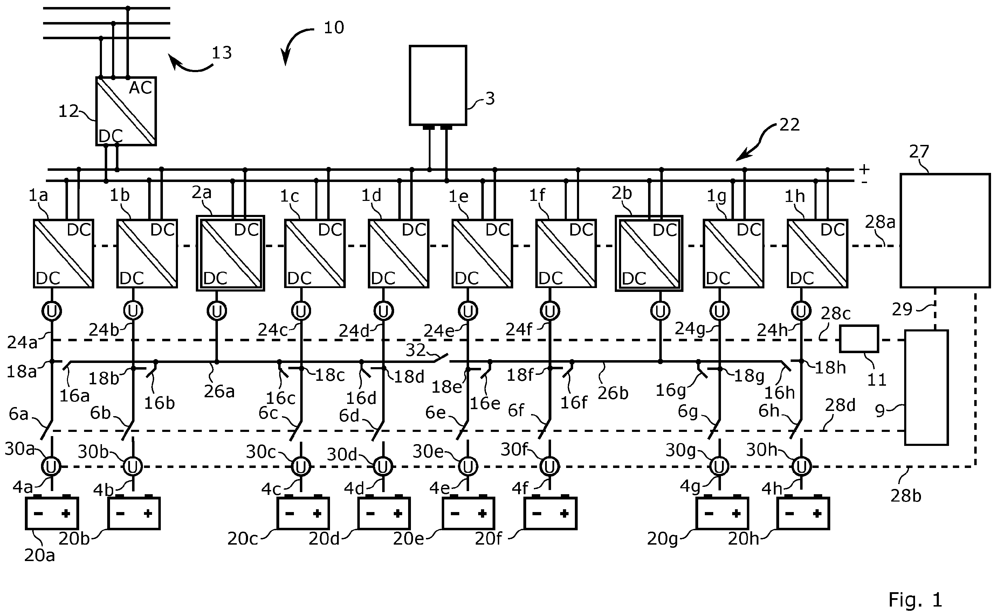

Figur 1 zeigt eine Schaltskizze eines erfindungsgemäßen Prüfsystems 10 gemäß einer besonderen Ausführungsform der Erfindung.

Das Prüfsystem 10 ist eingerichtet zur gleichzeitigen Prüfung mehrerer Prüflinge 20a-20h. Das Prüfsystem umfasst einen Gleichspannungszwischenkreis 22 mit dem wesentliche Elemente des Prüfsystems 10 in Verbindung stehen. Der Gleichspannungszwischenkreis 22 ist zweipolig gestaltet. Weiterhin umfasst das Prüfsystem 10 mehrere an den Gleichspannungszwischenkreis 22 angeschlossene Basis-Wandler 1a-1h. Die Basis-Wandler 1a-1h sind jeweils über eine Anschlussleitung 24 an einen Testkanal 4a-4h anschließbar. Es besteht somit eine eins-zu-eins-Kopplung zwischen Basis-Wandler 1a-h und Testkanal 4a-h. Jeder Testkanal 4a-4h steht mit genau einem der Basis-Wandler 1a-1h in elektrischer Verbindung.

Neben den acht Basis-Wandlern 1a-1h umfasst das Prüfsystem 10 ferner einen ersten an den Gleichspannungszwischenkreis 22 angeschlossenen Booster-Wandler 2a und einen zweiten an den Gleichspannungszwischenkreis 22 angeschlossenen Booster-Wandler 2b. Die Booster-Wandler 2a-2b sind jeweils über eine Boosterleitung 26a, 26b und jeweils einen Zuschaltknoten 18a-18h an verschiedene Anschlussleitungen 24 zu den Testkanälen 4a-4h zuschaltbar. Konkret erfolgt die Zuschaltung über Boosterschalter 16a-16h, mit denen eine Boosterleitung 26a, 26b mit mehreren Anschlussleitungen schaltbar verbunden ist. Die Anschlussleitungen 24 sind in Figur 1 aus Gründen der Übersichtlichkeit einpolig dargestellt, sind jedoch grundsätzlich mindestens zweipolig ausgestaltet. Explizit ist der Booster-Wandler 2a über die Boosterleitung 26a zu den Testkanälen 4a-4d zuschaltbar und der Booster-Wandler 2b über die Boosterleitung 26b zu den Testkanälen 4e-4h zuschaltbar, zumindest sofern keine Kopplung der beiden Boosterleitungen 26a-26b besteht, die im weiter unten diskutiert wird.

Jede Anschlussleitung 24a-24h weist einen sicherheitsgerichteten Schalter 6a-6h zwischen Testkanal 4a-4h und Zuschaltknoten 18a-18h auf. Grundsätzlich ist jeder der sicherheitsgerichteten Schalter 6a-6h derart ausgestaltet, dass jede Einzelleitung der mehrpoligen Anschlussleitungen 24a-24h schaltbar ist. Die Position der sicherheitsgerichteten Schalter 6a-6h ist auf einer Anschlussleitung 24a-24h zwischen Testkanal 4a-4h und Zuschaltknoten 18a-18h angeordnet.

Während eines Betriebs des Prüfsystems 10 ist der Booster-Wandler 2a über eine Boosterleitung 26a und jeweils einen Zuschaltknoten 18a-18d an jede der Anschlussleitungen 24a-24d und über diese zu den jeweiligen Testkanälen 4a-4d zuschaltbar. Entsprechend ist der Booster-Wandler 2b über die Boosterleitung 26b und die Zuschaltknoten 18e-18h an die Anschlussleitungen 24e-24h und über diese zu den jeweiligen Testkanälen 4e-4h zuschaltbar. Die Boosterleitungen 26a, 26b sind zwar mit mehreren der Anschlussleitungen 24a-24h verbindbar, um Kurzschlusse zwischen den Anschlussleitungen zu verhindern ist jedoch festgelegt, dass jede der Boosterleitungen 26a, 26b zu jedem Zeitpunkt mit jeweils nur einer der Anschlussleitungen 24a-24h verbindbar ist.

Das Prüfsystem 10 ermöglicht durch die 2 Booster-Wandler 2a, 2b und die 2 Boosterleitungen 26a, 26b die Versorgung von zwei separaten Testkanälen 4a-4h, jeweils einen aus der Gruppe der Testkanäle 4a-4d und einen aus der Gruppe 4e-4h. Die Boosterleitungen 26a, 26b sind über einen Kopplungsschalter 32 aber auch schaltbar miteinander verbunden und können durch diesen miteinander verbunden werden. Hierdurch wird ermöglicht, die Leistung eines Basis-Wandlers 1a-1h mit der Leistung des ersten Booster-Wandlers 2a und der Leistung des zweiten Booster-Wandlers 2b zu kombinieren. Hierdurch können weiter erhöhte Leistungen zu oder von einem Testkanal 4a-4h transferiert werden. Der Kopplungsschalter 32 ist ebenfalls mit dem Safety-System 9 verbunden, womit ebenfalls eine Kopplung von mehreren Testkanälen 4a-4h miteinander über eine Boosterleitung 26a, 26b verhindert wird.

Das Prüfsystem 10 umfasst ferner eine Steuereinheit 27 zur Steuerung der Basis-Wandler 1a-1h und der Booster-Wandler 2a, 2b entsprechend einem gewünschten Leistungstransfer. Hierzu ist die Steuereinheit 27 über eine erste Signalleitung 28a mit den Basis-Wandlern 1a-1h und den Booster-Wandlern 2a, 2b verbunden und über eine zweite Signalleitung 28b mit Spannungsmesseinrichtungen 30a-30h, welche dazu eingerichtet sind, die an den Testkanälen 4a-4h jeweils anliegende Spannungen zu messen. Die erste Signalleitung 28a ist dazu eingerichtet Steuerungssignale an die Basis-Wandler 1a-1h und die Booster-Wandler 2a, 2b zu senden. Über die zweite Signalleitung 28b wird jeweils eine am Testkanal 4a-4h anliegende Spannung gemessen. Die Signalleitungen 28a, 28b und 28c sind als gestrichelte Linien dargestellt. Ferner steht die Steuereinheit 27 über eine Verbindungsleitung mit dem Safety-System 9 in Verbindung. Alternativ kann das Safety-System 9 auch direkt in der Steuereinheit 27 integriert sein. Das Safety-System 9 ist dazu eingerichtet, die Sicherheit der Personen, die das Prüfsystem betreiben und die Sicherheit der Prüflinge 20a-20h zu gewährleisten. Es ist über Signalleitung 28c und einen Isolationsmonitor 11 mit den Anschlussleitungen 24a-24h verbunden. Der Isolationsmonitor 11 ist dazu eingerichtet, zyklisch zu messen, ob die galvanische Trennung der Basis-Wandler 1a-1h und der Booster-Wandler 2a, 2b zum Gleichspannungszwischenkreis funktioniert. Fehler in der galvanischen Trennung würden zur detektierbaren Schwankungen in den Anschlussleitungen 24a-24h führen. Weiter ist das Safety-System 9 über eine Signalleitung 28d mit den zwischen jeweils einem Testkanal 4a-4h und einem Zuschaltknoten 18a-18h angeordneten sicherheitsgerichteten Schaltern 6a-6h verbunden. Die Schaltung der sicherheitsgerichteten Schalter 6a-6h erfolgt üblicherweise durch ein von der Steuereinheit 27 über die Verbindungsleitung 29 an das Safety-System 9 gesendetes Schaltsignal. Nach Prüfung und Freigabe durch das Safety-System 9 schaltet das Safety-System 9 anschließend den sicherheitsgerichteten Schalter 6a-6d entsprechend dem empfangenen Schaltsignal. Davon unabhängig kann das Safety-System 9 jeden der sicherheitsgerichteten Schalter 6a-6h öffnen und so die elektrische Verbindung zu den Testkanälen 4a-4h und den Prüflingen 20a-20h unterbrechen. Dies kann insbesondere notwendig sein, wenn ein Fehler in der Funktionsweise der galvanischen Trennung der Basis-Wandler 1a-1h und/oder der Booster-Wandler 2a, 2b detektiert wird.

Das Safety-System 9 ist über eine weitere Signalleitung (nicht dargestellt) außerdem mit den Boosterschaltern 18a-18h verbunden. Die Boosterschalter 16a-16h, die zum Zuschalten von Boosterleistung eingerichtet sind. Das Safety-System 9 hat hierbei die Aufgabe, sicherzustellen, dass zu einem beliebigen Zeitpunkt jeweils nur ein oder kein Testkanal 4a-4h mit einer Boosterleitung 26a, 26b verbunden ist. Die Boosterschalter 16a-16h sind hierzu mit einem Safety-Torque-off-Schalter (STO-Schalter) ausgestattete Leistungshalbleiterschalter. Der STO-Schalter verzögert die sehr schnellen Schaltzeiten der Leistungshalbleiterschalter nicht, kann aber verhindern, dass der damit ausgestattete Boosterschalter 16a-16h überhaupt geschlossen werden kann. Das Safety-System kann zu jedem Zeitpunkt nur einen der STO-Schalter freigeben und dadurch verhindern, dass mehr als ein Boosterschalter 16a-16h pro getrennter Boosterleitung 26a, 26b geschlossen ist. Dies verhindert einen Kurzschluss zwischen zwei Testkanälen 4a-4h und einen damit einhergehenden ungewollten Leistungstransfer mit potenziellen Schäden am Prüfsystem 10 und technischem Personal.

Jede der Anschlussleitungen 24a-24h führt von jeweils einem Basis-Wandler 1a-1h zu jeweils einem Testkanal 4a-4h und, sofern ein solcher angeschlossen ist, zu jeweils einem Prüfling 20a-20h. Jede Anschlussleitung 24a-24h weist einen sicherheitsgerichteten Schalter 6a-6h zwischen Testkanal 4a-4h und Zuschaltknoten 18a-18h auf. Diese Anordnung erlaubt, sowohl durch die Basis-Wandler 1a-1h bereitgestellte Leistungen als auch durch die Booster-Wandler 2a, 2b verstärkte Leistungen sicherheitsgerichtet zu schalten.

Der Gleichspannungszwischenkreis 22 ist über einen Netzumrichter 12 an ein dreiphasiges Stromnetz 13 angeschlossen, dass den Gleichspannungszwischenkreis 22 mit elektrischer Leistung versorgt und über das elektrische Leistung abgeführt werden kann. Hierzu kann der Netzumrichter 12 als Active-Front-End-Wandler ausgestaltet sein. Eine in Figur 1 dargestellte galvanische Entkopplung des Netzumrichters 12 ist bei galvanischer Entkopplung aller Basis-Wandler 1a-1h und aller Booster-Wandler 2a, 2b nicht zwingend erforderlich.

Das Prüfsystem 10 umfasst ferner eine an den Gleichspannungszwischenkreis 22 angeschlossene Speichereinrichtung 3, die dazu eingerichtet ist, Leistung über die Basis-Wandler 1a-1h und die Booster-Wandler 2a, 2b von und zu den Testkanälen 4a-4h zu transferieren. Die Speichereinrichtung kann eine Batterie, einen Superkondensator und/oder einen Chopper umfassen.

In diesem Ausführungsbeispiel weist das Prüfsystem acht Basis-Wandler 1a-1h und zwei Booster-Wandler 2a, 2b auf. Das Verhältnis der Anzahl von Booster-Wandlern 2a, 2b zur Anzahl von Basis-Wandlern 1a-1h beträgt somit 1/4.

Zur Prüfung der fehlerfreien Funktionsweise des Prüfsystems 10 sind an verschiedenen Positionen elektrische Messgeräte angeordnet. Insbesondere bei Betrieb des Prüfsystems im Hochleistungsbereich ist über jedem Schalter eine Spannungsmessung durchzuführen, um abrupte Ausgleichsströme mit hohen Leistungen zu vermeiden. Hierzu ist über jedem der Schalter, insbesondere über jedem sicherheitsgerichteten Schalter, eine Spannungsmesseinrichtung 30a-30h vorgesehen, die dazu eingerichtet ist, auf beiden Seiten des Schalter die Spannung zu messen und sicherzustellen, dass beide Seiten des Schalters auf gleichem Potential liegen. Grundsätzlich kann an jeder Position, an der eine Spannungsmesseinrichtung 30a-30h vorgesehen ist, zusätzlich eine Strommesseinrichtung vorgesehen sein. Hierdurch wird zusätzlich eine Messung des Leistungstransfers an der jeweiligen Stelle ermöglicht. Aus Gründen der Übersichtlichkeit sind nicht alle Spannungsmesseinrichtungen 30a-30h in Figur 1 eingezeichnet.

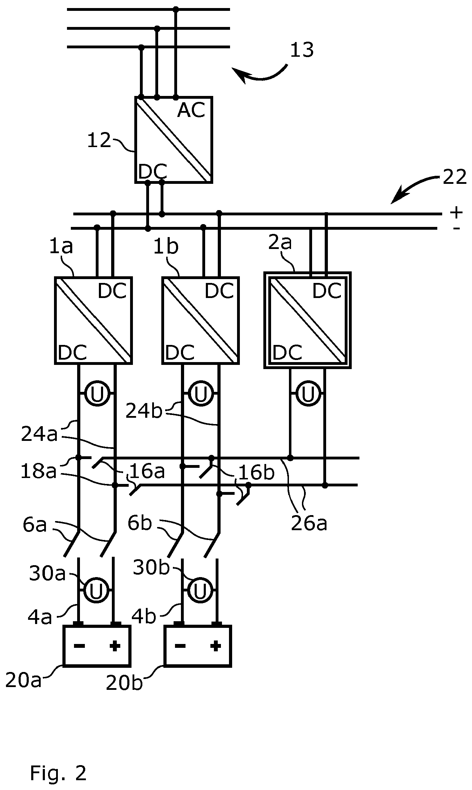

Figur 2 zeigt einen vergrößerten Ausschnitt der Schaltskizze von Figur 1, auf dem zusätzliche Details dargestellt sind. Wie in Zusammenhang mit Figur 1 beschrieben, sind in Figur 1 aus Gründen der Übersichtlichkeit einige Merkmale nicht im Detail dargestellt. Insbesondere zeigt Figur 2 im Detail, dass die von den Basis Wandlern 1a, 1b ausgehenden Anschlussleitungen 24a, 24b, ebenso wie der Gleichspannungszwischenkreis, zweiphasig ausgestaltet sind. Ferner ist im Detail dargestellt, dass die sicherheitsgerichteten Schalter 6a, 6b dazu eingerichtet sind, jede der Phasen der Anschlussleitungen 24a, 24b separat zu schalten. Weisen die sicherheitsgerichteten Schalter 6a, 6b eine Parallelschaltung von mehreren Schaltern auf, ist vorgesehen, dass jede der Phasen eine solche Parallelschaltung von mehreren Schaltern aufweist, wobei dies in der hier dargestellten besonderen Ausführungsform der Erfindung nicht dargestellt ist. Ferner ist die Boosterleitung 26a zweiphasig und die Boosterschalter 16a, 16b zum Schalten der mehrphasigen Boosterleitung ausgestaltet. Die Spannungsmesseinrichtungen 30a, 30b sind derart angeordnet, dass sie die Spannung zwischen den einzelnen Phasen des zweiphasigen Testkanals messen. Das Prüfsystem 10 ist in dem nicht in Figur 2 dargestellten Ausschnitt in gleicher Weise ausgestaltet, wie im in Figur 2 dargestellten Ausschnitt.

### Bezugszeichenliste:

- 1a-1h: Basis-Wandler
- 2a, 2b: Booster-Wandler
- 3: Speichereinrichtung
- 4a-4h: Testkanal
- 6a-6h: sicherheitsgerichteter Schalter
- 9: Safety-System
- 10: Prüfsystem
- 11: Isolationsmonitor
- 12: Netzumrichter
- 13: Stromnetz
- 16a-16h: Boosterschalter
- 18a-18h: Zuschaltknoten
- 20a-20h: Prüfling
- 22: Gleichspannungszwischenkreis
- 24a-24h: Anschlussleitung
- 26a, 26b: Boosterleitung
- 27: Steuereinheit
- 28a-28c: Signalleitung
- 29: Verbindungsleitung
- 30a-30h: Spannungsmesseinrichtung
- 32: Kopplungsschalter

## Patentansprüche

1. Prüfsystem (10) zur gleichzeitigen Prüfung mehrerer Batterien, insbesondere Hochvoltbatterien, umfassend:
einen Gleichspannungszwischenkreis (22),
mehrere an den Gleichspannungszwischenkreis (22) angeschlossene Basis-Wandler (1a-1h), die jeweils über eine Anschlussleitung (24a-24h) mit einem Testkanal (4a-4h) schaltbar verbunden sind, **gekennzeichnet durch**
einen an den Gleichspannungszwischenkreis (22) angeschlossenen Booster-Wandler (2a, 2b), der während eines Betriebs des Prüfsystems (10) über eine Boosterleitung (26a, 26b) und jeweils einen Zuschaltknoten (18a-18h) an verschiedene der Anschlussleitungen (24a-24h) zu wenigstens einem der Testkanäle (4a-4h) zuschaltbar ist,
eine Steuereinheit (27) zur Steuerung der Basis-Wandler (1a-1h) und des Booster-Wandlers (2a, 2b) entsprechend einem gewünschten Leistungstransfer; wobei
jede Anschlussleitung (24a-24h) einen sicherheitsgerichteten Schalter (6a-6h) zwischen Testkanal (4a-4h) und Zuschaltknoten (18a-18h) aufweist, wobei der sicherheitsgerichtete Schalter (6a-6h) dazu eingerichtet ist, den eigenen Schaltzustand und/oder eine eigene Fehlfunktion zu detektieren oder detektierbar zu machen.

2. Prüfsystem (10) Anspruch 1, wobei der Gleichspannungszwischenkreis (22) über einen Netzumrichter (12) an ein Stromnetz (13) angeschlossen ist.

3. Prüfsystem (10) Anspruch 1 oder 2, ferner umfassend eine Speichereinrichtung (3), die dazu eingerichtet ist, Leistung zu wenigstens einem der Testkanäle (4a-4h) oder von wenigstens einem der Testkanäle (4a-4h) zu transferieren, wobei die Speichereinrichtung (3) an den Gleichspannungszwischenkreis (22) angeschlossen ist.

4. Prüfsystem (10) nach einem der vorhergehenden Ansprüche, wobei die Speichereinrichtung (3) einen Chopper umfasst.

5. Prüfsystem (10) nach einem der Ansprüche 2 bis 4, ferner umfassend einen Active-Front-End-Wandler, der dazu eingerichtet ist, Leistung in das Stromnetz (13) oder aus dem Stromnetz (13) zu transferieren.

6. Prüfsystem (10) nach einem der vorhergehenden Ansprüche, wobei der Basis-Wandler (1a-1h) in einem ersten Leistungsbereich betreibbar ist und der Booster-Wandler (2a, 2b) in einem zweiten Leistungsbereich betreibbar ist und der erste Leistungsbereich kleiner ist als der zweite Leistungsbereich.

7. Prüfsystem (10) nach einem der vorhergehenden Ansprüche, wobei das Verhältnis der Anzahl von Booster-Wandlern (2a, 2b) zur Anzahl von Basis-Wandlern (1a-1h) im Prüfsystem (10) zwischen 1/2 und 1/6, insbesondere zwischen 1/3 und 1/5 beträgt.

8. Prüfsystem (10) nach einem der vorhergehenden Ansprüche, wobei über jedem der sicherheitsgerichteten Schalter (6a-6h) eine Spanungsmesseinrichtung (30a-30h) angeordnet ist.

9. Prüfsystem (10) nach einem der vorhergehenden Ansprüche, wobei wenigstens einer der sicherheitsgerichteten Schalter (6a-6h) eine Parallelschaltung von mehreren Schaltern (6a-6h) aufweist.

10. Prüfsystem (10) nach einem der vorhergehenden Ansprüche, wobei wenigstens einer der sicherheitsgerichteten Schalter (6a-6h) zur Schaltung von einem mit Rippelstrom überlagertem Gleichstrom eingerichtet ist.

11. Prüfsystem (10) nach einem der vorhergehenden Ansprüche, wobei die Speichereinrichtung (3) einen schnellen Speicher mit schneller Zugriffszeit und einen langsamen Speicher mit langsamer Zugriffszeit umfasst, und der schnelle Speicher eine geringere Kapazität als der langsame Speicher aufweist.

12. Prüfsystem (10) nach einem der vorhergehenden Ansprüche, wobei die Boosterleitung (26a, 26b) einen Boosterschalter (16a-16h) zum Zuschalten einer Boosterleistung zu wenigstens einem der Testkanäle (4a-4h) umfasst.

13. Prüfsystem (10) nach einem der vorhergehenden Ansprüche, wobei die Basis-Wandler (1a-1h) und/oder der oder die Booster-Wandler (2a, 2b) jeweils Stützkondensatoren aufweisen und eine Ausgangskapazität der Stützkondensatoren des Booster-Wandlers (2a, 2b) oder der Booster-Wandler (2a, 2b) kleiner ist als eine Ausgangskapazität von Stützkondensatoren der Basis-Wandler (1a-1h).

14. Prüfsystem (10) nach einem der vorhergehenden Ansprüche, wobei wenigstens einer der Basis-Wandler (1a-1h) gegenüber dem Gleichspannungszwischenkreis (22) galvanisch getrennt ist.

15. Prüfsystem (10) nach einem der vorhergehenden Ansprüche, wobei die sicherheitsgerichteten Schalter (6a-6h) signaltechnisch mit einem Safety-System (9) verbunden sind.

16. Prüfsystem (10) nach einem der vorhergehenden Ansprüche, wobei das Prüfsystem (10) einen zweiten an den Gleichspannungszwischenkreis (22) angeschlossenen Booster-Wandler (2a, 2b), der während eines Betriebs des Prüfsystems (10) zu der Boosterleitung (26a, 26b) zuschaltbar ist, umfasst.

17. Verfahren zur Prüfung von einem oder mehreren Prüflingen (20a-20h) mit einem Prüfsystem (10) nach einem der vorhergehenden Ansprüche, umfassend die Schritte:
a) Anschließen eines Prüflings (20a-20h) an einem der Testkanäle (4a-4h);
b) Starten eines Prüflaufs an dem Prüfling (20a-20h);
c) Senden einer Leistungsanforderung für einen Testkanal (4a-4h) an die Steuereinheit (27);
d) Überprüfen, ob die angeforderte Leistung betragsmäßig größer ist als die vom Basis-Wandler (1a-1h) transferierbare Leistung
e) Verbinden des Booster-Wandlers (2a, 2b) mit einem der Testkanäle (4a-4h), wenn die angeforderte Leistung betragsmäßig größer ist als die vom Basis-Wandler (1a-1h) transferierbare Leistung;
f) Transferieren der angeforderten Leistung über den Basis-Wandler (1a-1h) und den Booster-Wandler (2a, 2b).

18. Verfahren nach Anspruch 17, wobei die Leistungsanforderung wenigstens 1µs, vorzugsweise wenigstens 100µs vor Bereitstellung der Leistung an die Steuereinheit (27) gesendet wird.

## Claims

1. Test system (10) for the simultaneous testing of multiple batteries, in particular high-voltage batteries, comprising:
a DC voltage intermediate circuit (22),
a plurality of base converters (1a-1h) connected to the DC voltage intermediate circuit (22), each base converter being switchably connected via a connection line (24a-24h) to a test channel (4a-4h), **characterized by**
a booster converter (2a, 2b) connected to the DC voltage intermediate circuit (22), which, during operation of the test system (10), is connectable via a booster line (26a, 26b) and a respective switching node (18a-18h) to different ones of the connection lines (24a-24h) to at least one of the test channels (4a-4h),
a control unit (27) configured to control the base converters (1a-1h) and the booster converter (2a, 2b) in accordance with a desired power transfer; wherein
each connection line (24a-24h) comprises a safety-oriented switch (6a-6h) arranged between the test channel (4a-4h) and the switching node (18a-18h), the safety-oriented switch (6a-6h) being configured to detect, or to make detectable, its own switching state and/or its own malfunction.

2. Test system (10) according to claim 1, wherein the DC voltage intermediate circuit (22) is connected to a power supply grid (13) via a mains inverter (12).

3. Test system (10) according to claim 1 or 2, further comprising a storage device (3) configured to transfer power to at least one of the test channels (4a-4h) or from at least one of the test channels (4a-4h), wherein the storage device (3) is connected to the DC voltage intermediate circuit (22).

4. Test system (10) according to any one of the preceding claims, wherein the storage device (3) comprises a chopper.

5. Test system (10) according to any one of claims 2 to 4, further comprising an active front-end converter which is configured to transfer power to the power supply grid (13) or from the power supply grid (13).

6. Test system (10) according to any one of the preceding claims, wherein the base converter (1a-1h) is operable in a first power range and the booster converter (2a, 2b) is operable in a second power range, and the first power range is smaller than the second power range.

7. Test system (10) according to any one of the preceding claims, wherein the ratio of the number of booster converters (2a, 2b) to the number of base converters (1a-1h) in the test system (10) is between 1/2 and 1/6, and preferably between 1/3 and 1/5.

8. Test system (10) according to any one of the preceding claims, wherein a voltage measuring device (30a-30h) is arranged above each of the safety-related switches (6a-6h).

9. Test system (10) according to any one of the preceding claims, wherein at least one of the safety-related switches (6a-6h) comprises a parallel connection of several switches (6a-6h).

10. Test system (10) according to any one of the preceding claims, wherein at least one of the safety-related switches (6a-6h) is configured to switch a direct current that is superimposed with ripple current.

11. Test system (10) according to any one of the preceding claims, wherein the storage device (3) comprises a fast storage with fast access time and a slow storage with slow access time, and the fast storage comprises a lower capacity than the slow storage.

12. Test system (10) according to any one of the preceding claims, wherein the booster line (26a, 26b) comprises a booster switch (16a-16h) for switching a boost power to at least one of the test channels (4a-4h).

13. Test system (10) according to any one of the preceding claims, wherein the base converter (1a-1h) and/or the booster converter(s) (2a, 2b) each comprises back-up capacitors and an output capacitance of the back-up capacitors of the booster converter (2a, 2b) or the booster converters (2a, 2b) is less than an output capacitance of the back-up capacitors of the base converters (1a-1h).

14. Test system (10) according to any one of the preceding claims, wherein at least one of the base converters (1a-1h) is galvanically isolated from the DC voltage intermediate circuit (22).

15. Test system (10) according to any one of the preceding claims, wherein the safety-related switches (6a-6h) are signal-technically connected to a safety system (9).

16. Test system (10) according to any one of the preceding claims, wherein the test system (10) comprises a second booster converter (2a, 2b) connected to the DC voltage intermediate circuit (22) which is connectable to the booster line (26a, 26b) during operation of the test system (10).

17. Method for testing one or more devices under test (20a-20h) using a test system (10) according to any one of the preceding claims, comprising the steps of:
a) connecting a device under test (20a-20h) to one of the test channels (4a-4h);
b) starting a test run on the device under test (20a-20h);
c) transmitting a power request for a test channel (4a-4h) to the control unit (27);
d) checking whether the requested power is, in absolute terms, greater than the power transferable by the base converter (1a-1h);
e) connecting the booster converter (2a, 2b) to one of the test channels (4a-4h) when the requested power is, in absolute terms, greater than the power transferable by the base converter (1a-1h);
f) transferring the requested power via the base converter (1a-1h) and the booster converter (2a, 2b).

18. Method according to claim 17, wherein the power request is sent to the control unit (27) at least 1µs, preferably at least 100µs, prior to providing the power.

## Revendications

1. Système de test (10) pour tester simultanément plusieurs batteries, en particulier des batteries haute tension, comprenant :
un circuit intermédiaire à tension continue (22),
plusieurs convertisseurs de base (1a-1h) raccordés au circuit intermédiaire à tension continue (22), qui sont chacun reliés de manière commutable à un canal de test (4a-4h) via une ligne de raccordement (24a-24h), **caractérisé par**
un convertisseur booster (2a, 2b) raccordé au circuit intermédiaire à tension continue (22), qui, pendant le fonctionnement du système de contrôle (10), peut être connecté à différents câbles de raccordement (24a-24h) via un câble booster (26a, 26b) et un nœud de connexion (18a-18h) respectif à au moins l'un des canaux de test (4a-4h),
une unité de commande (27) pour commander les convertisseurs de base (1a-1h) et le convertisseur booster (2a, 2b) en fonction d'un transfert de puissance souhaité ;
chaque ligne de connexion (24a-24h) comportant un interrupteur de sécurité (6a-6h) entre le canal de test (4a-4h) et le nœud de connexion (18a-18h), le commutateur de sécurité (6a-6h) étant conçu pour détecter ou rendre détectable son propre état de commutation et/ou son propre dysfonctionnement.

2. Système de test (10) selon la revendication 1, dans lequel le circuit intermédiaire à tension continue (22) est connecté à un réseau électrique (13) via un convertisseur de réseau (12).

3. Système de test (10) selon la revendication 1 ou 2, comprenant en outre un dispositif de stockage (3) qui est conçu pour transférer de l'énergie vers au moins l'un des canaux de test (4a-4h) ou à partir d'au moins l'un des canaux de test (4a-4h), le dispositif de stockage (3) étant connecté au circuit intermédiaire à tension continue (22).

4. Système de test (10) selon l'une des revendications précédentes, le dispositif de stockage (3) comprenant un hacheur.

5. Système de test (10) selon l'une des revendications 2 à 4, comprenant en outre un convertisseur à front actif qui est conçu pour transférer de l'énergie vers le réseau électrique (13) ou à partir du réseau électrique (13).

6. Système de test (10) selon l'une des revendications précédentes, dans lequel le convertisseur de base (1a-1h) peut fonctionner dans une première plage de puissance et le convertisseur booster (2a, 2b) peut fonctionner dans une deuxième plage de puissance, la première plage de puissance étant inférieure à la deuxième plage de puissance.

7. Système de test (10) selon l'une des revendications précédentes, dans lequel le rapport entre le nombre de convertisseurs boosters (2a, 2b) et le nombre de convertisseurs de base (1a-1h) dans le système de test (10) est compris entre 1/2 et 1/6, en particulier entre 1/3 et 1/5.

8. Système de contrôle (10) selon l'une des revendications précédentes, dans lequel un dispositif de mesure de tension (30a-30h) est disposé au-dessus de chacun des interrupteurs de sécurité (6a-6h).

9. Système de contrôle (10) selon l'une des revendications précédentes, dans lequel au moins l'un des commutateurs de sécurité (6a-6h) comporte un montage en parallèle de plusieurs commutateurs (6a-6h).

10. Système de contrôle (10) selon l'une des revendications précédentes, dans lequel au moins l'un des commutateurs de sécurité (6a-6h) est conçu pour commuter un courant continu superposé à un courant ondulé.

11. Système de test (10) selon l'une des revendications précédentes, dans lequel le dispositif de stockage (3) comprend une mémoire rapide avec un temps d'accès rapide et une mémoire lente avec un temps d'accès lent, et la mémoire rapide présente une capacité inférieure à celle de la mémoire lente.

12. Système de test (10) selon l'une des revendications précédentes, dans lequel la ligne d'amplification (26a, 26b) comprend un commutateur d'amplification (16a-16h) pour connecter une puissance d'amplification à au moins l'un des canaux de test (4a-4h).

13. Système de test (10) selon l'une des revendications précédentes, dans lequel les convertisseurs de base (1a-1h) et/ou le ou les convertisseurs amplificateurs (2a, 2b) comportant chacun des condensateurs de support et une capacité de sortie des condensateurs de support du convertisseur amplificateur (2a, 2b) ou des convertisseurs amplificateurs (2a, 2b) étant inférieure à une capacité de sortie des condensateurs de support des convertisseurs de base (1a-1h).

14. Système de contrôle (10) selon l'une des revendications précédentes, dans lequel au moins l'un des convertisseurs de base (1a-1h) est isolé galvaniquement par rapport au circuit intermédiaire à tension continue (22).

15. Système de contrôle (10) selon l'une des revendications précédentes, dans lequel les commutateurs de sécurité (6a-6h) sont reliés par signalisation à un système de sécurité (9).

16. Système de test (10) selon l'une des revendications précédentes, dans lequel le système de test (10) comprend un deuxième convertisseur élévateur (2a, 2b) connecté au circuit intermédiaire à tension continue (22), qui peut être connecté à la ligne élévatrice (26a, 26b) pendant le fonctionnement du système de test (10).

17. Procédé pour tester un ou plusieurs échantillons (20a-20h) à l'aide d'un système de test (10) selon l'une des revendications précédentes, comprenant les étapes suivantes :
a) raccorder un échantillon (20a-20h) à l'un des canaux de test (4a-4h) ;
b) lancement d'un cycle de test sur l'échantillon (20a-20h) ;
c) envoi d'une demande de puissance pour un canal de test (4a-4h) à l'unité de commande (27) ;
d) vérification si la puissance demandée est supérieure à la puissance transférable par le convertisseur de base (1a-1h)
e) connexion du convertisseur booster (2a, 2b) à l'un des canaux de test (4a-4h) si la puissance demandée est supérieure à la puissance transférable par le convertisseur de base (1a-1h) ;
f) transfert de la puissance demandée via le convertisseur de base (1a-1h) et le convertisseur booster (2a, 2b).

18. Procédé selon la revendication 17, dans lequel la demande de puissance est envoyée à l'unité de commande (27) au moins 1 µs, de préférence au moins 100 µs avant la fourniture de la puissance.
